# EUROPÄISCHE PATENTSCHRIFT

(11) **EP 0 481 222 B1**
(45) Veröffentlichungstag und Bekanntmachung des Hinweises auf die Patenterteilung: **03.04.1996**
(21) Anmeldenummer: 91115637.0
(22) Anmeldetag: 14.09.1991
(51) Int. Cl.: G01R 31/28, G01R 35/00, G01R 31/00, G01M 15/00

(54) **Vorrichtung zum Prüfen eines Kraftfahrzeugtestsystems**
Test device for a vehicle test-system
Dispositif pour contrôler un système de test de véhicule

(30) Priorität: 17.10.1990 DE 4032926
(43) Veröffentlichungstag der Anmeldung: 22.04.1992
(73) Patentinhaber: ROBERT BOSCH GMBH, D-70442 Stuttgart (DE)
(72) Erfinder: Etzold, Peter, Dipl.-Ing., W-7333 Ebersbach (DE)

(56) Entgegenhaltungen:
- GB-A- 2 055 214
- US-A- 4 425 791
- US-A- 4 517 839
- US-A- 4 518 915

## Beschreibung

### Stand der Technik

Die Erfindung geht aus von einem Kraftfahrzeugtestsystem nach der Gattung des Hauptanspruchs. In dem Dokument US-A-4 425 791 ist ein derartiges Kraftfahrzeugtestsystem offenbart. Auch in dem Dokument EP-A-0 458 053 (vgl. Artikel 54(3) EPÜ) ist ein derartiges Kraftfahrzeugtestsystem beschrieben, das eine Testvorrichtung mit einem an einem Ausleger befestigten Peripheriegerät enthält, an dem über flexible Meß- oder Prüfkabel unterschiedliche Diagnosevorrichtungen mittels Steckverbindungen angeschlossen werden können. Bei einer aufgetretenen Betriebsstörung kann ein in der Testvorrichtung vorhandenes rechnergesteuertes Prüfprogramm kleinere Fehler selbst ermitteln und dem Benutzer entsprechende Hinweise geben. Ein solches Prüfprogramm kann jedoch nicht alle Fehler analysieren. Im allgemeinen muß deshalb ein Servicetechniker benachrichtigt werden, der mit speziellen Prüfgeräten das Testsystem untersucht. Neben Fehlerzuständen des Testsystems, die vom Benutzer erkannt werden, kann es Fehler geben, die unerkannt bleiben. Ein solcher Fehler kann beispielsweise von einer der Diagnosevorrichtungen ausgehen, die einen Meßwert vortäuscht, der nicht vorliegt. Sofern ein solcher Fehler überhaupt vermutet wird, gibt es für den Benutzer derzeit keine Möglichkeit einer einfachen Überprüfung, ob der Fehler in der Diagnosevorrichtung oder innerhalb der Testvorrichtung aufgetreten ist.

Der Erfindung liegt die Aufgabe zugrunde, eine einfache Vorrichtung zum Prüfen eines Kraftfahrzeugtestsystems anzugeben.

Die Aufgabe wird durch die im Hauptanspruch angegebenen Merkmale gelöst.

### Vorteile der Erfindung

Die erfindungsgemäße Vorrichtung weist den Vorteil auf, daß mit einfachen Mitteln eine Aussage darüber möglich ist, ob ein Fehler in der Diagnosevorrichtung oder innerhalb der Testvorrichtung vorliegt. Hierzu ist eine Prüfvorrichtung vorgesehen, die anstelle der Diagnosevorrichtung über die Schnittstelle mit der Testvorrichtung verbindbar ist.

Vorteilhafte Weiterbildungen und Verbesserungen der im Hauptanspruch angegebenen Vorrichtung ergeben sich aus Unteransprüchen.

Besonders vorteilhaft ist es, wenn die Testvorrichtung mehrere gleichartige Steckverbindungen zum Anschluß von unterschiedlichen Diagnosevorrichtungen enthält, wobei die Kontaktbelegung der Steckvorrichtung in der Testvorrichtung und in den Diagnosevorrichtungen so aufeinander abgestimmt ist, daß eine Prüfvorrichtung an mehrere Steckverbindungen der Testvorrichtungen angeschlossen werden kann.

In vorteilhaften Ausgestaltungen enthält die erfindungsgemäße Prüfvorrichtung Anzeigeelemente und/oder Simulationselemente und/oder Stimulieinheiten, die Meßwerte für die Testvorrichtung erzeugen.

Als Stimulieinheit ist beispielsweise eine Gleichspannungsquelle oder ein Rechteckgenerator vorgesehen. Weitere vorteilhafte Weiterbildungen ergeben sich aus weiteren Unteransprüchen in Verbindung mit der folgenden Beschreibung.

### Zeichnung

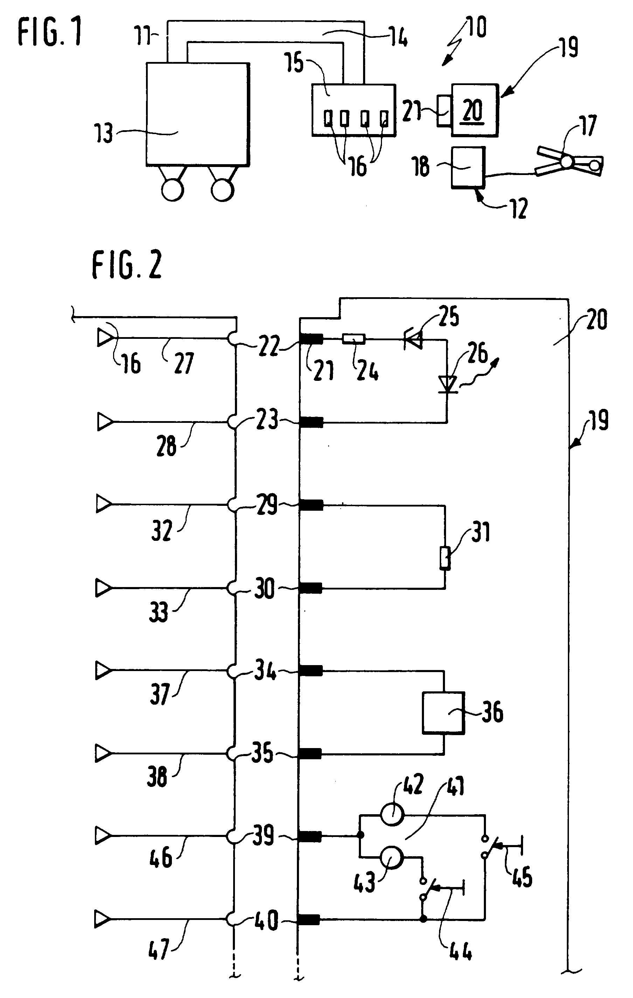

Figur 1 zeigt ein Testsystem mit einer Test- und Diagnosevorrichtung, die über eine Schnittstelle miteinander verbindbar sind, und Figur 2 zeigt eine erfindungsgemäße Prüfvorrichtung zum Anschluß an die Schnittstelle.

In Figur 1 ist ein Kraftfahrzeugtestsystem 10 gezeigt, das eine Testvorrichtung 11 und wenigstens eine Diagnosevorrichtung 12 enthält. Die Testvorrichtung 11 ist aus einem Grundgerät 13, das in Figur 1 nicht näher gezeigte Anzeige- und/oder Bedienelemente enthält, einem, vorzugsweise drehbar gelagerten Ausleger 14 sowie aus einem am Ausleger 14 angeordneten Peripheriegerät 15 zusammengesetzt. Das Peripheriegerät 15 enthält vier Schnittstellen 16, an die die unterschiedlichen Diagnosevorrichtungen 12 angeschlossen werden können.

Als Diagnosevorrichtung 12 ist in Figur 1 beispielhaft eine Strommeßzange 17 gezeigt, die mittels eines Verbindungsteils 18 an eine der Schnittstellen 16 anschließbar ist. Anstelle der Diagnosevorrichtung 12 ist an die Schnittstelle 16 eine erfindungsgemäße Prüfvorrichtung 19 anschließbar, die ein Gehäuse 20 sowie ein Anschlußteil 21 aufweist.

In Figur 2 ist eine der Schnittstellen 16 gezeigt, die beispielsweise als erstes Teil einer mehrpoligen Steckverbindung realisiert ist. Das Anschlußteil 21 der Prüfvorrichtung 19 ist als Gegenstück zum ersten Teil der Steckverbindung ausgebildet. Im folgenden werden die Schnittstelle 16 und das Anschlußstück 21 als Steckverbindung 16, 21 bezeichnet, die zwei Teile enthält. Im Gehäuse 20 der Prüfvorrichtung 19 ist zwischen einem ersten und zweiten Kontakt der Steckverbindung 16, 21 eine Reihenschaltung aus einem Widerstand, einer Begrenzerdiode und einer Leuchtdiode geschaltet. Die an den ersten und zweiten Kontakt 22, 23 führenden Leitungen 27, 28 führen Signale, die von der Testvorrichtung 11 nach außen abgegeben werden. Die Signalabgabe ist durch Pfeile an den Leitungen 27, 28 angedeutet.

Zwischen einem dritten und vierten Kontakt 29, 30 der Steckverbindung 16, 21 ist in der Prüfvorrichtung 19 ein Widerstand 31 geschaltet.

An einem fünften und sechsten Kontakt 34, 35 ist in der Prüfvorrichtung 19 eine erste Stimulieinheit 36 angeordnet.

An einem siebten und achten Kontakt 39, 40 ist in der Prüfvorrichtung 19 eine zweite Stimulieinheit 41 angeschlossen, die eine erste und zweite Spannungsquelle 42, 43 enthält. Die zweite Stimulieinheit 41 ist mittels Tastschalter 44, 45 mit dem achten Kontakt 40 der Steckverbindung 16, 21 verbindbar.

Die erfindungsgemäße Vorrichtung arbeitet folgendermaßen:

Das in Figur 1 gezeigte Kraftfahrzeugtestsystem 10 enthält wenigstens die eine Diagnosevorrichtung 12, die in Figur 1 beispielhaft als Strommeßvorrichtung mit der Strommeßzange 17 ausgestaltet ist. Die Diagnosevorrichtung 12 ist beweglich und ermöglicht eine einfache Adaption an einem zu testenden Kraftfahrzeug. Die Diagnosevorrichtung 12 ist über eine der Schnittstellen 16 mit der Testvorrichtung 11 verbindbar. Die Testvorrichtung 11 kann stationär oder fahrbar auf Rollen ausgelegt sein. Die in Figur 1 gezeigte Ausgestaltung der Testvorrichtung 11 mit dem Grundgerät 13 und dem Pheripheriegerät 15, das mit dem Grundgerät 13 über den drehbar gelagerten Ausleger 14 verbunden ist, ist nicht zwingend erforderlich. Die Schnittstellen 16 können ebenso an einem Grundgerät 13 unmittelbar angeordnet sein. Die Schnittstellen 16 sind vorteilhafterweise als erste Teile von Steckverbindungen realisiert, die mit jeweils einem zweiten Teil der Steckverbindungen zusammenwirken die am Verbindungsteil 18 der Diagnosevorrichtung 12 angeordnet sind.

Erfindungsgemäß ist die im Gehäuse 20 angeordnete Prüfvorrichtung 19 vorgesehen, deren Anschlußteil 21 ebenfalls als zweites Teil der Steckverbindung 16, 21 ausgebildet ist. Falls in dem Kraftfahrzeugtestsystem 10 eine Betriebsstörung auftritt, so kann der Benutzer zumindest feststellen, ob der Fehler innerhalb der Testvorrichtung 11 oder in der Diagnosevorrichtung 12 zu suchen ist. Die erfindungsgemäße Prüfvorrichtung 19 gestattet auch die Überprüfung der Kalibrierung der Kraftfahrzeugtestvorrichtung 10, die das Erkennen von nicht offensichtlichen Fehlern ermöglicht.

Die Prüfvorrichtung 19 wird hierzu anstelle der Diagnosevorrichtung 20 auf den ersten Teil 16 der Steckverbindung gesteckt.

Besonders vorteilhaft ist es, wenn mehrere gleichartige erste Teile 16 der Steckvorrichtung vorgesehen sind, wobei eine einzige Prüfvorrichtung 19 mit sämtlichen ersten Teilen 16 verbindbar ist. Zu diesem Zweck ist die Kontaktbelegung der Steckverbindung 16, 21 sowohl in der Test 11-, der Diagnose 12-, und der Prüfvorrichtung 19 aufeinander abzustimmen. Die Steckerbelegung sowie Details der Prüfvorrichtung 19 sind in Figur 2 gezeigt.

Zwischen dem ersten und zweiten Kontakt 22, 23 ist die Reihenschaltung aus dem Widerstand 24, der Begrenzerdiode 25 und der Leuchtdiode 26 vorgesehen. Die Reihenschaltung 24, 25, 26 enthält die Leuchtdiode 26 als Anzeigevorrichtung, die beispielsweise das Vorhandensein eines bestimmten Spannungspegels zwischen dem ersten und zweiten Kontakt 22, 23 anzeigt. Diese Prüfmöglichkeit kann vorgesehen sein, wenn die Testvorrichtung 11 über die Leitungen 27, 28 eine Ausgangsspannung an den Kontakten 22, 23 zur Verfügung stellt, die beispielsweise eine Betriebsspannung einer in den Figuren nicht gezeigten Stroboskoplampe sein, die ein weiteres Beispiel einer Diagnosevorrichtung 12 ist.

Zwischen dem dritten und vierten Anschluß 29, 30 der Steckverbindung 16, 21 ist der Widerstand 31 angeschlossen, der ein Simulationselement für eine Widerstandsmessung darstellt, die über die Leitungen 32, 33 von der Testvorrichtung 11 vorgenommen wird. Das Simulationselement 31 weist ein passives Verhalten auf.

Ein aktives Verhalten dagegen weisen die beiden Stimulieinheiten 36, 41 auf, die selbst Signale abgeben, die der Testvorrichtung 11 zugeleitet werden.

An dem fünften und sechsten Kontakt 34, 35 der Steckverbindung 16, 21 ist die erste Stimulieinheit 36 angeschlossen, die beispielsweise einen Signalgenerator enthält. Der Signalgenerator kann beispielsweise ein rechteckförmiges Signal abgeben, das ein Signal simuliert, das an einem in den Figuren nicht gezeigten Unterbrecher des zu testenden Kraftfahrzeugs auftreten kann.

Die am siebten und achten Kontakt 39, 40 angeschlossene zweite Stimulieinheit 41 stellt beispielsweise zwei unterschiedliche Testspannungen mit den beiden Spannungsquellen 42, 43 bereit. Die beiden Tastschalter 44, 45 ermöglichen die Auswahl entweder einer der Spannungsquellen 42, 43 oder beider Quellen gleichzeitig.

## Patentansprüche

1. Kraftfahrzeugtestsystem (10), das eine Testvorrichtung (11) sowie eine über eine Schnittstelle (16) mit der Testvorrichtung (11) verbindbare bewegliche Diagnosevorrichtung (12) enthält, gekennzeichnet durch eine Prüfvorrichtung (19), die anstelle der Diagnosevorrichtung (12) über die Schnittstelle (16) mit der Testvorrichtung (11) verbindbar ist.

2. Kraftfahrzeugtestsystem nach Anspruch 1, dadurch gekennzeichnet, daß die Schnittstelle (16) als erstes Teil und ein Anschlußteil (21) der Prüfvorrichtung (19) als zweites Teil einer Steckverbindung (16, 21) ausgebildet sind, die mehrere Kontakte (22, 23, 29, 30, 34, 35, 39, 40) enthält.

3. Kraftfahrzeugtestsystem nach Anspruch 2, dadurch gekennzeichnet, daß die Testvorrichtung (11) mehrere gleichartige erste Teile (16) der Steckverbindung (16, 21) zum Anschluß von unterschiedlichen Diagnosevorrichtungen (12) enthält und daß die Kontaktbelegungen in der Testvorrichtung (11), in der Diagnosevorrichtung (12) sowie in der Prüfvorrichtung (19) aufeinander abgestimmt sind, so daß eine Prüfvorrichtung (19) an jeweils einem der mehreren ersten Teile (16) der Steckverbindung (16, 21) anschließbar ist.

4. Kraftfahrzeugtestsystem nach einem der vorhergehenden Ansprüche, dadurch gekennzeichnet, daß die Prüfvorrichtung (19) eine Anzeige (26) enthält.

5. Kraftfahrzeugtestsystem nach Anspruch 4, dadurch gekennzeichnet, daß als Anzeige (26) wenigstens eine Leuchtdiode vorhanden ist.

6. Kraftfahrzeugtestsystem nach einem der vorhergehenden Ansprüche, dadurch gekennzeichnet, daß wenigstens ein Simulationselement (31) in der Prüfvorrichtung (19) vorhanden ist.

7. Kraftfahrzeugtestsystem nach Anspruch 6, dadurch gekennzeichnet, daß wenigstens ein ohmscher Widerstand (31) als Simulationselement vorhanden ist.

8. Kraftfahrzeugtestsystem nach einem der vorhergehenden Ansprüche, dadurch gekennzeichnet, daß die Prüfvorrichtung (19) einen Signalgenerator (36) zum Zuführen von Signalen an die Testvorrichtung (11) enthält.

9. Kraftfahrzeugtestsystem nach einem der vorhergehenden Ansprüche, dadurch gekennzeichnet, daß die Prüfvorrichtung (19) wenigstens eine Gleichspannungsquelle (42, 43) zum Zuführen einer Gleichspannung an die Testvorrichtung (11) enthält.

10. Kraftfahrzeugtestsystem nach Anspruch 8 oder 9, dadurch gekennzeichnet, daß der Signalgenerator (36) und/oder die wenigstens eine Gleichspannungsquelle (42, 43) mit einem Tastschalter (44, 45) einschaltbar sind/ist.

## Claims

1. Motor vehicle test system (10) which contains a test device (11) as well as a movable diagnosis device (12) which can be connected via an interface (16) to the test device (11), characterized by a testing device (19) which can be connected to the test device (11) via the interface (16) instead of the diagnosis device (12).

2. Motor vehicle test system according to Claim 1, characterized in that the interface (16) is designed as a first part, and a connecting part (21) of the testing device (19) as a second part, of a plug connection (16, 21) which contains a plurality of contacts (22, 23, 29, 30, 34, 35, 39, 40).

3. Motor vehicle test system according to Claim 2, characterized in that the test device (11) contains a plurality of identical first parts (16) of the plug connection (16, 21) for the connection of different diagnosis devices (12), and in that the contact assignments in the test device (11), in the diagnosis device (12) and in the testing device (19) are matched to one another such that a testing device (19) can in each case be connected to one of the plurality of first parts (16) of the plug connection (16, 21).

4. Motor vehicle test system according to one of the preceding claims, characterized in that the testing device (19) contains an indicator (26).

5. Motor vehicle test system according to Claim 4, characterized in that at least one light-emitting diode is provided as the indicator (26).

6. Motor vehicle test system according to one of the preceding claims, characterized in that at least one simulation element (31) is provided in the testing device (19).

7. Motor vehicle test system according to Claim 6, characterized in that at least one non-reactive resistor (31) is provided as the simulation element.

8. Motor vehicle test system according to one of the preceding claims, characterized in that the testing device (19) contains a signal generator (36) for supplying signals to the test device (11).

9. Motor vehicle test system according to one of the preceding claims, characterized in that the testing device (19) contains at least one DC voltage source (42, 43) for supplying a DC voltage to the test device (11).

10. Motor vehicle test system according to Claim 8 or 9, characterized in that the signal generator (36) and/or the at least one DC voltage source (42, 43) can be switched on by means of a push-button switch (44, 45).

## Revendications

1. Système de contrôle de véhicule automobile (10) comprenant un dispositif de contrôle (11) ainsi qu'un dispositif de diagnostic (12), mobile, susceptible d'être relié au dispositif de contrôle (11) par une interface (16), caractérisé en ce qu'un dispositif de vérification (19) peut être branché au dispositif de contrôle (11) par l'interface (16) à la place du dispositif de diagnostic (12).

2. Système de contrôle de véhicule automobile selon la revendication 1, caractérisé en ce que l'interface (16) est réalisée comme première partie et un connecteur (21) du dispositif de vérification (19) est réalisé comme seconde partie d'une liaison à connecteur (16, 21) à plusieurs contacts (22, 23, 29, 30, 34, 35, 39, 40).

3. Système de contrôle de véhicule automobile selon la revendication 2, caractérisé en ce que le dispositif de contrôle (11) comporte plusieurs premières parties identiques (16) du connecteur (16, 21) pour le branchement du dispositif de diagnostic (12) différent, et en ce que l'occupation des contacts dans le dispositif de contrôle (11), dans le dispositif de diagnostic (12) ainsi que dans le dispositif de vérification (19), sont accordés respectivement pour qu'un dispositif de vérification (19) puisse se brancher chaque fois sur l'une des différentes premières parties (16) du connecteur (16, 21).

4. Système de contrôle de véhicule automobile selon l'une des revendications précédentes, caractérisé en ce que le dispositif de vérification (19) comporte un moyen d'affichage (26) .

5. Système de contrôle de véhicule automobile selon la revendication 4, caractérisé en ce que le moyen d'affichage (26) est constitué par au moins une diode.

6. Dispositif de contrôle de véhicule selon l'une quelconque des revendications précédentes, caractérisé par au moins un élément de simulation (31) dans le dispositif de vérification (19).

7. Dispositif de contrôle de véhicule selon la revendication 6, caractérisé par au moins une résistance ohmique (31) comme élément de simulation.

8. Dispositif de contrôle de véhicule selon l'une des revendications précédentes, caractérisé en ce que le dispositif de vérification (19) comporte un générateur de signaux (36) pour fournir des signaux au dispositif de contrôle (11).

9. Système de contrôle de véhicule automobile selon l'une des revendications précédentes, caractérisé en ce que le dispositif de vérification (19) comporte au moins une source de tension continue (42, 43) pour appliquer une tension continue au dispositif de contrôle (11).

10. Système de contrôle de véhicule automobile selon la revendication 8 ou 9, caractérisé en ce que le générateur de signaux (36) et/ou au moins l'une des sources de tension continue (42, 43) peuvent se brancher par un connecteur à touches (44, 45).
